# EUROPEAN PATENT SPECIFICATION

(11) **EP 4 593 542 B1**
(45) Date of publication and mention of the grant of the patent: **28.10.2026**
(21) Application number: 23882923.8
(22) Date of filing: 26.09.2023
(51) Int. Cl.: H05K 9/00

(54) **STRETCHABLE SURFACE-MOUNT GASKET**
DEHNBARE OBERFLÄCHENMONTIERTE DICHTUNG
JOINT D'ÉTANCHÉITÉ À MONTAGE EN SURFACE ÉTIRABLE

(30) Priority: 26.10.2022 KR 20220139473
(43) Date of publication of application: 30.07.2025
(73) Proprietor: Samsung Electronics Co., Ltd., Suwon-si, Gyeonggi-do 16677 (KR)
(72) Inventor: LEE, Jungsoo, Suwon-si Gyeonggi-do 16677 (KR)
(74) Representative: Walaski, Jan Filip
(86) International application number: PCT/KR2023/014846
(87) International publication number: WO 2024/090816

(56) References cited:
- CN-U- 209 693 360
- JP-A- 2017 073 523
- KR-B1- 100 920 469
- KR-B1- 101 708 787
- KR-B1- 101 854 318
- US-A1- 2006 211 276

## Description

### [Technical Field]

The disclosure relates to a surface mount gasket, and more particularly, to a stretchable surface mount gasket capable of increasing and decreasing its length.

### [Background Art]

Electromagnetic waves generated from electronic components of electronic devices may be radiated to the outside through the atmosphere or conducted through wires. In the design of electronic devices, various electromagnetic waves generated by electronic components may affect surrounding electronic devices, thereby lowering the performance of the electronic devices. In addition, electromagnetic waves may also affect the human body.

To address these problems caused by electromagnetic waves, electromagnetic shielding gaskets are used. Electromagnetic shielding gaskets may be disposed on printed circuit boards of electronic devices such as cell phones, TVs, monitors, computers, etc. to block external radiation of electromagnetic waves generated from various electronic components.

As electronic devices become smaller, electromagnetic shielding gaskets may be mounted on printed circuit boards using surface mounting technology.

Surface mount gaskets may be disposed on printed circuit boards used in electronic devices such as mobile phones, TVs, monitors, etc. to reduce electromagnetic interference noise when the electronic devices are in operation and heat generated from electronic components through grounding.

CN 209693360 U discloses an electromagnetic interference shielding gasket including multi-bend spring fingers.

KR 101708787 B1 discloses a method for manufacturing a conductive gasket for surface mounting from a stainless steel sheet.

KR 101854318 B1 discloses an elastic heat dissipation terminal.

### [Disclosure of Invention]

### [Technical Solution]

According to an aspect of the invention, there is provided a surface mount gasket as set out in claim 1. According to one or more embodiments of the disclosure, a surface mount gasket 1 includes an upper plate 10; a lower plate 20 arranged below the upper plate 10; and a plurality of connection members 30 connecting the upper plate 10 and the lower plate 20. One end of each of the plurality of connection members 30 is connected to an edge of the upper plate 10, and another end thereof is connected to an edge of the lower plate 20. The plurality of connection members 30 are disposed at a specified interval along the edge of the upper plate 10 and the edge of the lower plate 20.

According to one or more embodiments of the disclosure, each of the plurality of connection members 30 may be inclined with respect to the upper plate 10 and the lower plate 20.

According to one or more embodiments of the disclosure, each of the plurality of connection members 30 may be formed of an elastic material having a thin flat plate shape with a narrow width and a long length.

According to one or more embodiments of the disclosure, the plurality of connection members 30 are formed of a sponge. A metal coating layer may be formed on an outer surface of the sponge.

According to one or more embodiments of the disclosure, the upper plate 10, the lower plate 20, and the plurality of connection members 30 may be integrally formed of a non-conductive elastic material. A conductive coating layer may be formed on an outer surface of the upper plate 10, an outer surface of the lower plate 20, and outer surfaces of the plurality of connection members 30.

According to one or more embodiments of the disclosure, the surface mount gasket may further include a double-sided tape 40 disposed on an upper surface of the upper plate 10.

According to one or more embodiments of the disclosure, each of the plurality of connection members 30 may be formed by being bent at least once.

According to one or more embodiments of the disclosure, each of the plurality of connection members 30 may be formed in two X-shapes connected in a longitudinal direction.

According to one or more embodiments of the disclosure, the plurality of connection members 30 are formed in a mesh shape or in a net shape.

According to one or more embodiments of the disclosure, the upper plate 10 and the lower plate 20 may be formed in one of a circle, an oval, and a rectangle.

According to one or more embodiments of the disclosure, each of the plurality of connection members 30 may include an upper vertical portion, an inclined portion, and a lower vertical portion.

According to one or more embodiments of the disclosure, each of the plurality of connection members 30 may include an upper vertical portion, a bend portion, and a lower vertical portion.

### [Brief Description of Drawings]

These and/or other aspects, features, and advantages of certain embodiments of the disclosure will be more apparent from the following description taken in conjunction with the accompanying drawings, in which:
FIG. 1 is a perspective view illustrating a surface mount gasket 1 according to one or more embodiments of the disclosure.
FIG. 2 is a cross-sectional view illustrating a surface mount gasket 1 according to one or more embodiments of the disclosure.
FIG. 3 is a perspective view illustrating a surface mount gasket 1 according to one or more embodiments of the disclosure.
FIG. 4 is a view illustrating a state in which a surface mount gasket 1 according to one or more embodiments of the disclosure is disposed on a printed circuit board 50.
FIG. 5 is a view illustrating a state before a surface mount gasket 1 according to one or more embodiments of the disclosure is attached to a printed circuit board 50.
FIG. 6 is a view illustrating a state in which a surface mount gasket 1 according to one or more embodiments of the disclosure is disposed on a printed circuit board 50.
FIG. 7 is a view illustrating a case where a surface mount gasket 1 according to one or more embodiments of the disclosure is disposed on a printed circuit board 50 in a compressed state.
FIG. 8A is a view illustrating a case where a surface mount gasket 1 according to one or more embodiments of the disclosure is disposed on a printed circuit board 50.
FIG. 8B is a view illustrating a state where a surface mount gasket 1 according to one or more embodiments of the disclosure is extended in length and adhered to a heat pipe 60.
FIG. 9 is a perspective view illustrating a surface mount gasket 1 according to one or more embodiments of the disclosure.
FIG. 10 is a perspective view illustrating a surface mount gasket 1 according to one or more embodiments of the disclosure.
FIG. 11 is a perspective view illustrating a surface mount gasket 1 according to one or more embodiments of the disclosure.
FIG. 12 is a perspective view illustrating a surface mount gasket 1 according to one or more embodiments of the disclosure.
FIG. 13 is a perspective view illustrating a surface mount gasket 1 according to one or more embodiments of the disclosure.

### [Best Mode for Carrying out the Invention]

Since various embodiments of the disclosure can apply various transformations and have various embodiments, specific embodiments will be illustrated in the drawings and described in detail in the detailed description. However, this is not intended to limit the scope to the specific embodiments, and should be understood to include various modifications, equivalents, and/or alternatives of the embodiment of the disclosure. In connection with the description of the drawings, like reference numerals may be used for like elements.

In describing the disclosure, when it is determined that a detailed description of a related known function or configuration may unnecessarily obscure the disclosure, a detailed description thereof will be omitted.

In addition, the following embodiments may be modified in many different forms, and the scope of the technical idea of the disclosure is not limited to the following embodiments. Rather, these embodiments are provided so that this disclosure will be thorough and complete, and will fully convey the disclosure to those skilled in the art.

Terms used in this disclosure are only used to describe specific embodiments. Singular expressions include plural expressions unless the context clearly dictates otherwise.

In this disclosure, expressions such as "has," "can have", "includes," or "can include" indicate the existence of a corresponding feature (e.g., numerical value, function, operation, or component such as a part) and do not preclude the existence of additional features.

In this disclosure, expressions such as "A or B," "at least one of A or/and B," or "one or more of A or/and B" may include all possible combinations of the items listed together. For example, "A or B," "at least one of A or/and B," or "one or more of A or/and B" may refer to all cases (1) including at least one A, (2) including at least one B, or (3) including both at least one A and at least one B.

Expressions such as "first," "second," "primary," or "secondary," as used in this disclosure may modify various components regardless of order and/or importance, are used only to distinguish one component from other components, and do not limit the corresponding components.

Further, terms such as 'leading end', 'rear end', 'upper side', 'lower side', 'top end', 'bottom end', etc. used in the disclosure are defined with reference to the drawings. However, the shape and position of each component are not limited by these terms.

The disclosure is provides a surface mount gasket 1 capable of transmitting electromagnetic waves or heat by connecting a ground of a printed circuit board and a heat pipe or a heat sink when a distance between the ground and the heat pipe or the heat sink is outside a tolerance range of a design distance.

Hereinafter, embodiments of a surface mount gasket 1 according to the disclosure will be described in detail with reference to the attached drawings.

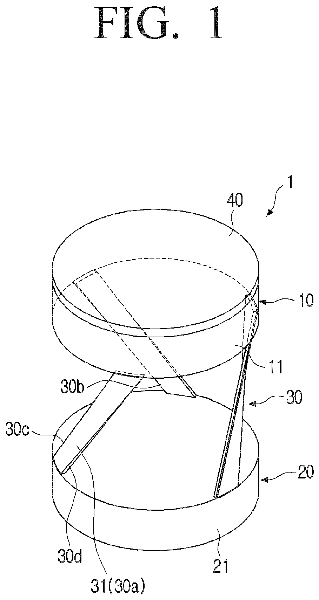

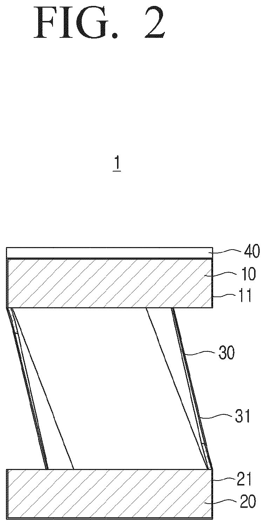

FIG. 1 is a perspective view illustrating a surface mount gasket 1 according to one or more embodiments of the disclosure. FIG. 2 is a cross-sectional view illustrating a surface mount gasket 1 according to one or more embodiments of the disclosure.

Referring to FIGS. 1 and 2, a surface mount gasket 1 according to one or more embodiments of the disclosure includes an upper plate 10, a lower plate 20, and a plurality of connection members 30.

The upper plate 10 may be formed in a flat plate shape. The upper plate 10 may be formed in a circular, rectangular, or oval shape.

The lower plate 20 may be placed below the upper plate 10, and may be formed in a shape corresponding to the upper plate 10. The lower plate 20 may be firmed in a flat plate. The lower plate 20 may be formed in a circular, rectangular, or oval shape. The lower plate 20 may be disposed parallel to the upper plate 10.

The plurality of connection members 30 may be disposed between the upper plate 10 and the lower plate 20. The plurality of connection members 30 are formed to connect the upper plate 10 and the lower plate 20.

The plurality of connection members 30 are disposed at the edges of the upper plate 10 and the lower plate 20. The plurality of connection members 30 are disposed along the edges of the upper plate 10 and the lower plate 20. The plurality of connection members 30 are disposed at a certain interval along the edge of the upper plate 10 and the edge of the lower plate 20.

The plurality of connection members 30 may be formed in the same shape. Therefore, a single connection member 30 will be described below.

One end of the connection member 30 is connected to the edge of the upper plate 10, and the other end thereof is connected to the edge of the lower plate 20.

The connection member 30 may be disposed at an angle with respect to the upper plate 10 and the lower plate 20. In other words, the connection member 30 may not be disposed at a right angel to the upper plate 10 and the lower plate 20. The connection member 30 may be disposed to form an acute or obtuse angle with respect to the upper plate 10 and the lower plate 20.

Therefore, a straight line connecting one end of the connection member 30 connected to the upper plate 10 and the other end of the connection member 30 connected to the lower plate 20 may not be parallel to a virtual straight line perpendicular to the upper plate 10 and the lower plate 20. **In** other words, one end of the connection member 30 connected to the upper plate 10 may not be located on a virtual straight line that is perpendicular to the lower plate 20 and passes through the other end of the connection member 30 connected to the lower plate 20.

Each of the plurality of connection members 30 may be formed in a thin flat plate shape with a narrow width and a long length. The connection member 30 may include an upper surface, a lower surface, a front surface 30a, a rear surface 30b, a left surface 30c, and a right surface 30d.

The upper surface of the connection member 30 may be fixed to the edge of the upper plate 10, and the lower surface thereof may be fixed to the edge of the lower plate 20. The connection member 30 may be disposed integrally the upper plate 10 and the lower plate 20 so as not to be separated from the upper plate 10 and the lower plate 20.

The connection member 30 may be disposed so that the front surface 30a and the rear surface 30b thereof form a right angle with respect to the upper plate 10 and the lower plate 20.

The connection member 30 may be disposed so that the left surface 30c thereof forms an acute angle with respect to the upper plate 10 and an obtuse angle with respect to the lower plate 20. In this case, the right surface 30d of the connection member 30 may form an obtuse angle with respect to the upper plate 10 and an acute angle with respect to the lower plate 20.

For example, the acute angle formed between one side surface 30c and 30d of the connection member 30 and the upper plate 10 or the lower plate 20 may be about 20 degrees to about 70 degrees. In this case, the obtuse angle formed between the other side surface 30d and 30c of the connection member 30 and the lower plate 20 or the upper plate 10 may be about 110 degrees to about 160 degrees.

The upper plate 10, the lower plate 20, and the plurality of connection members 30 may be integrally formed of the same material.

The upper plate 10, the lower plate 20, and the connection members 30 may be formed of a non-conductive deformable elastic material. The elastic material used in the disclosure may have a small restoring force and a property of being flexibly bent. In other words, the elastic material may have stretchability and elasticity. For example, a sponge, a flexible filament, nylon, etc. may be used as the elastic material.

Accordingly, the surface mount gasket 1 according to one or more embodiments of the disclosure may not be formed of a metal having a large restoring force. In addition, the surface mount gasket 1 according to one or more embodiments of the disclosure may not be formed of a plastic material having a large restoring force that may be used in the manufacture of a spring.

The upper plate 10, the lower plate 20, and the plurality of connection members 30 may be integrally formed of a non-conductive elastic material. Then, the distance between the upper plate 10 and the lower plate 20 may be adjusted. That is, the length of the surface mount gasket 1 may be reduced or increased. In other words, the surface mount gasket 1 may be increased or decreased in length within a certain range. For example, the surface mount gasket 1 may be increased or decreased in length within about 1 mm.

Conductive coating layers 11, 21, and 31 may be formed on the outer surface of the upper plate 10, the outer surface of the lower plate 20, and the outer surfaces of the plurality of connection members 30, that is, the front surfaces 30a of the plurality of connection members 30. The conductive coating layers 11, 21, and 31 may be formed to have electrical conductivity and thermal conductivity.

Then, electromagnetic waves and heat may flow through the conductive coating layers 11, 21, and 31 of the upper plate 10, the plurality of connection members 30, and the lower plate 20.

For example, the upper plate 10, the lower plate 20, and the plurality of connection members 30 may be formed of a sponge and metal coating layers 11, 21, and 31 formed on the outer surface of the sponge. In detail, the upper plate 10, the lower plate 20, and the plurality of connection members 30 may be formed of a sponge, and a metal coating may be applied to the outer surface of the sponge forming the upper plate 10, the lower plate 20, and the plurality of connection members 30, thereby forming the metal coating layers 11, 21, and 31. Then, the sponge may provide elasticity to adjust the length of the surface mount gasket 1, and the metal coating layers 11, 21, and 31 may allow electromagnetic waves and heat to flow through the upper plate 10, the plurality of connection members 30, and the lower plate 20.

The surface mount gasket 1 according to one or more embodiments of the disclosure may include a double-sided tape 40 disposed on the upper surface of the upper plate 10.

The double-sided tape 40 may enable a component located on the upper side of the surface mount gasket 1 to maintain stable contact with the upper plate 10 of the surface mount gasket 1.

The double-sided tape 40 may have electrical conductivity and thermal conductivity.

In the case of the surface mount gasket 1 shown in FIGS. 1 and 2, three connection members 30 are disposed between the upper plate 10 and the lower plate 20. In other words, the three connection members 30 may be arranged at intervals of about 120 degrees along the upper plate 10 and the lower plate 20.

However, the number of the plurality of connection members 30 of the surface mount gasket 1 according to one or more embodiments of the disclosure is not limited thereto. Four or more of connection members 30 may be used as needed.

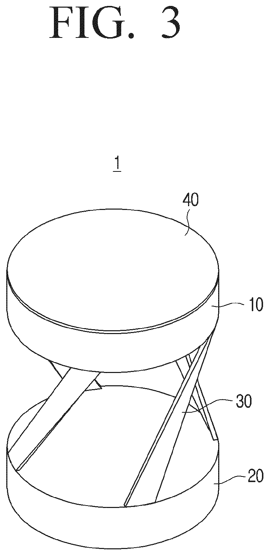

For example, as illustrated in FIG. 3, four connection members 30 may be disposed between the upper plate 10 and the lower plate 20.

FIG. 3 is a perspective view illustrating a surface mount gasket 1 according to one or more embodiments of the disclosure including four connection members 30.

Referring to FIG. 3, four connection members 30 may be disposed to connect the edge of the upper plate 10 and the edge of the lower plate 20. The four connection members 30 may be arranged at approximately 90 degrees intervals along the edges of the upper plate 10 and the lower plate 20. The four connection members 30 may be arranged at an angle with respect to the upper plate 10 and the lower plate 20.

The surface mount gasket 1 illustrated in FIG. 3 differs from the surface mount gasket 1 illustrated in FIG. 1 and FIG. 2 only in the number of connection members 30, so a detailed description thereof is omitted.

The surface mount gasket 1 according to one or more embodiments of the disclosure having the above-described structure may be disposed on a printed circuit board 50.

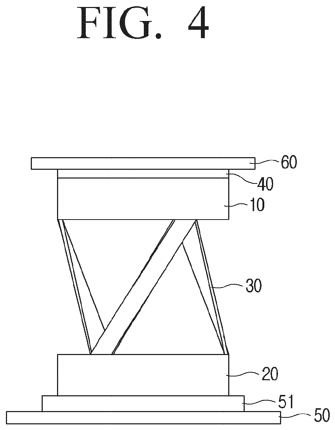

FIG. 4 is a view illustrating a state in which a surface mount gasket 1 according to one or more embodiments of the disclosure is disposed on a printed circuit board 50.

Referring to FIG. 4, the surface mount gasket 1 according to one or more embodiments of the disclosure may be disposed between the printed circuit board 50 and a heat pipe 60. The heat pipe 60 may be connected to an integrated circuit (IC) 70.

The lower plate 20 of the surface mount gasket 1 may be attached to a ground 51 of the printed circuit board 50. The lower plate 20 may be fixed to the ground 51 of the printed circuit board 50 by a surface mount technology. In other words, the lower plate 20 may be fixed to the ground 51 of the printed circuit board 50 by soldering.

The upper plate 10 of the surface mount gasket 1 may be in contact with the heat pipe 60.

The heat generated from the integrated circuit 70 may be transferred to the upper plate 10 of the surface mount gasket 1 through the heat pipe 60. Then, the heat may be transferred to the ground 51 of the printed circuit board 50 through the conductive coating layers provided on the outer surface of the surface mount gasket 1.

In addition, electromagnetic noise generated from the integrated circuit 70 may be discharged to the ground 51 of the printed circuit board 50 through the heat pipe 60 and the surface mount gasket 1.

In the case where the double-sided tape 40 is disposed on the upper plate 10 of the surface mount gasket 1, the upper plate 10 of the surface mount gasket 1 may be fixed to the lower surface of the heat pipe 60 with the double-sided tape 40.

Then, the heat generated from the integrated circuit 70 may be transferred to the upper plate 10 of the surface mount gasket 1 through the heat pipe 60 and the double-sided tape 40. Then, the heat may be transferred to the ground 51 of the printed circuit board 50 through the conductive coating layers provided on the outer surface of the surface mount gasket 1.

In addition, the electromagnetic noise generated from the integrated circuit 70 may be discharged to the ground 51 of the printed circuit board 50 through the heat pipe 60, the double-sided tape 40, and the surface mount gasket 1.

Because the surface mount gasket 1 according to one or more embodiments of the disclosure has the upper plate 10 and the lower plate 20 formed in flat plates, the contact area between the heat pipe 60 and the ground 51 by the surface mount gasket 1 may be increased. Accordingly, the surface mount gasket 1 according to one or more embodiments of the disclosure may increase the effect of transmitting electromagnetic waves and heat to the ground 51.

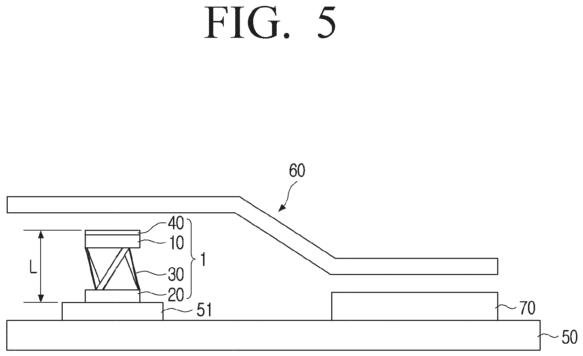

The surface mount gasket 1 according to one or more embodiments of the disclosure may be used when the distance between the ground 51 of the printed circuit board 50 and the heat pipe 60 is smaller or larger than the design distance within a certain range outside the tolerance range of the design distance. This will be described in detail below with reference to FIGS. 5 to 8.

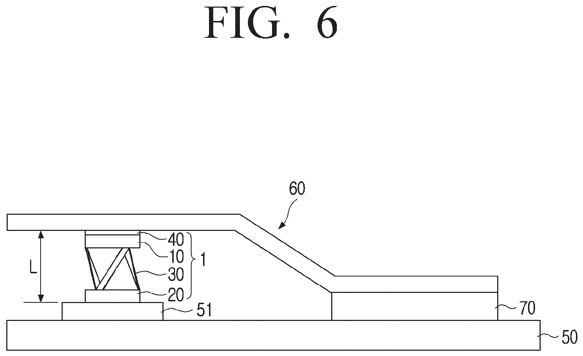

FIG. 5 is a view illustrating a state before a surface mount gasket 1 according to one or more embodiments of the disclosure is attached to a printed circuit board 50. FIG. 6 is a view illustrating a state in which a surface mount gasket 1 according to one or more embodiments of the disclosure is disposed on a printed circuit board 50.

Referring to FIG. 5, the integrated circuit 70 and the ground 51 may be provided on the upper surface of the printed circuit board 50.

The surface mount gasket 1 may be disposed on the ground 51 of the printed circuit board 50. In detail, the lower plate 20 of the surface mount gasket 1 may be attached to the ground 51 using the surface mounting technology. The surface mount gasket 1 may have a reference length L. In this case, the reference length L of the surface mount gasket 1 refers to the length from the upper surface of the double-sided tape 40 to the lower surface of the lower plate 20.

The heat pipe 60 may be disposed above the integrated circuit 70 and the surface mount gasket 1. In other words, one end portion of the heat pipe 60 may be disposed on the upper surface of the integrated circuit 70, and the other end portion of the heat pipe 60 may be disposed on the upper plate 10 of the surface mount gasket 1. Accordingly, the integrated circuit 70 and the surface mount gasket 1 may be connected to each other by the heat pipe 60.

The state in which the heat pipe 60 is disposed is illustrated in FIG. 6.

Referring to FIG. 6, the one end portion of the heat pipe 60 may be fixed to the upper surface of the integrated circuit 70, and the other end portion of the heat pipe 60 may be fixed to the upper plate 10 of the surface mount gasket 1. The upper plate 10 of the surface mount gasket 1 and the heat pipe 60 may be attached to each other with the double-sided tape 40.

In this case, the distance between the ground 51 and the heat pipe 60 is the same as or similar to the reference length L of the surface mount gasket 1, so there is no need to increase or decrease the length of the surface mount gasket 1. In other words, when the distance between the ground 51 and the heat pipe 60 is the design distance, there is no need to increase or decrease the length of the surface mount gasket 1.

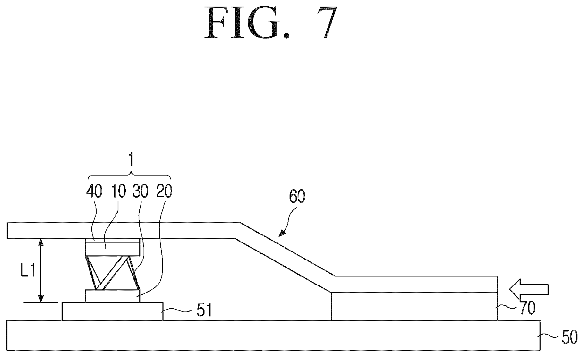

However, the distance between the ground 51 and the heat pipe 60 may be smaller than the design distance. In other words, the distance between the ground 51 and the heat pipe 60 may be smaller than the reference length L of the surface mount gasket 1. In this case, when the heat pipe 60 is disposed on the integrated circuit 70 and the upper plate 10 of the surface mount gasket 1, the surface mount gasket 1 may be compressed and its length may be reduced. This case is illustrated in FIG. 7.

FIG. 7 is a view illustrating a case where a surface mount gasket 1 according to one or more embodiments of the disclosure is disposed on a printed circuit board 50 in a compressed state.

Referring to FIG. 7, when the distance between the ground 51 and the heat pipe 60 is smaller than the reference length L of the surface mount gasket 1, the surface mount gasket 1 may be compressed and its length may be reduced. In other words, the length of the surface mount gasket 1 disposed between the ground 51 and the heat pipe 60 is L1, which is smaller than the reference length L (L1 < L).

In this case, since the surface mount gasket 1 according to one or more embodiments of the disclosure has a small restoring force, the force that the compressed surface mount gasket 1 applies to the heat pipe 60 may be smaller than the adhesive force between the heat pipe 60 and the integrated circuit 70. Accordingly, the heat pipe 60 may not be separated from the integrated circuit 70 by the compressed surface mount gasket 1.

When the distance between the ground 51 and the heat pipe 60 is smaller than the reference length L of the surface mount gasket 1, the double-sided tape 40 may not be disposed on the upper plate 10 of the surface mount gasket 1. In other words, the surface mount gasket 1 may be disposed so that the upper plate 10 of the surface mount gasket 1 directly contacts the lower surface of the heat pipe 60.

Meanwhile, the distance between the ground 51 and the heat pipe 60 may be larger than the design distance. In other words, the distance D between the ground 51 and the heat pipe 60 may be larger than the reference length L of the surface mount gasket 1.

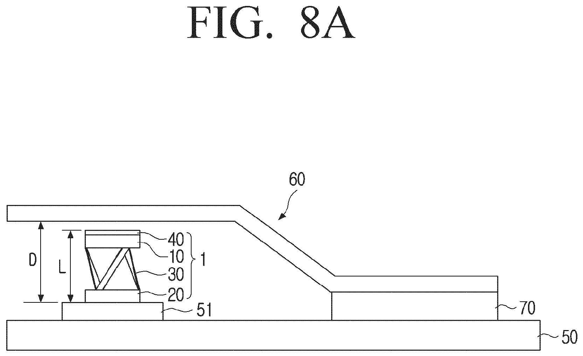

In this case, when the heat pipe 60 is disposed on the integrated circuit 70 and the upper surface of the surface mount gasket 1, the upper surface of the surface mount gasket 1 may not contact the lower surface of the heat pipe 60. In other words, the double-sided tape 40 of the surface mount gasket 1 may not be attached to the lower surface of the heat pipe 60. This case is illustrated in FIG. 8A. FIG. 8A is a view illustrating a case where a surface mount gasket 1 according to one or more embodiments of the disclosure is disposed on a printed circuit board 50.

In such a case, the surface mount gasket 1 according to one or more embodiments of the disclosure may be increased in length. In detail, when the surface mount gasket 1 is pulled in the longitudinal direction, the length of the surface mount gasket 1 may be increased, so that the double-sided tape 40 disposed on the upper plate 10 of the surface mount gasket 1 may be attached to the lower surface of the heat pipe 60.

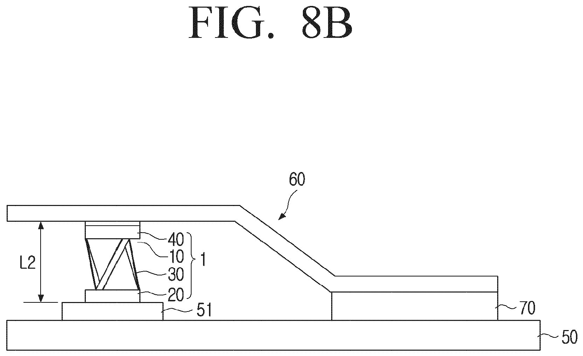

This state is illustrated in FIG. 8B. FIG. 8B is a view illustrating a state where a surface mount gasket 1 according to one or more embodiments of the disclosure is extended in length and adhered to a heat pipe 60. In this case, the length L2 of the extended surface mount gasket 1 is larger than the reference length L of the surface mount gasket 1. In other words, the length L2 of the extended surface mount gasket 1 may be equal to the distance D between the ground 51 and the heat pipe 60.

In this case, since the restoring force of the surface mount gasket 1 according to one or more embodiments of the disclosure is smaller than the adhesive force of the double-sided tape 40, the double-sided tape 40 of the surface mount gasket 1 may not be separated from the lower surface of the heat pipe 60. Accordingly, heat and electromagnetic waves generated from the integrated circuit 70 may be transmitted to the ground 51 of the printed circuit board 50 through the surface mount gasket 1.

As described above, the surface mount gasket 1 according to one or more embodiments of the disclosure may connect the ground 51 and the heat pipe 60 when the distance between the ground 51 and the heat pipe 60 is greater than or less than the reference length L of the surface mount gasket 1 within a certain range.

Therefore, the surface mount gasket 1 according to one or more embodiments of the disclosure may have the advantage of reducing the types of surface mount gasket 1 according to the length.

Hereinafter, a surface mount gasket 1 having connection members 30 of various shapes will be described with reference to the attached drawings.

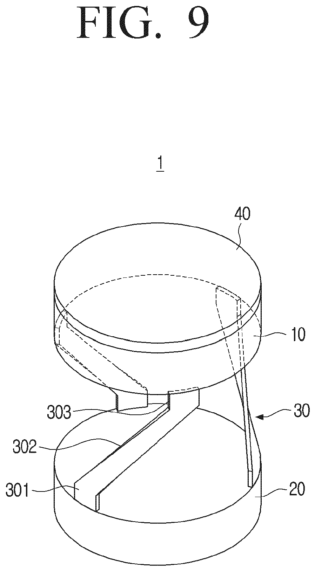

FIG. 9 is a perspective view illustrating a surface mount gasket 1 according to one or more embodiments of the disclosure.

Referring to FIG. 9, a surface mount gasket 1 according to one or more embodiments of the disclosure may include an upper plate 10, a lower plate 20, and a plurality of connection members 30. In addition, the surface mount gasket 1 may include a double-sided tape 40 disposed on the upper surface of the upper plate 10.

The upper plate 10, the lower plate 20, and the double-sided tape 40 are the same as those of the surface mount gasket 1 according to the above-described embodiment; therefore, detailed descriptions thereof are omitted.

Each of the plurality of connection members 30 may be disposed at an angle with respect to the upper plate 10 and the lower plate 20. One end of each of the plurality of connection members 30 may be disposed at an edge of the upper plate 10, and the other end thereof may be disposed at an edge of the lower plate 20. The plurality of connection members 30 may be disposed at a certain interval along the edge of the upper plate 10 and the edge of the lower plate 20.

The plurality of connection members 30 may be formed identically. Accordingly, a single connection member 30 will be described below.

The connection member 30 may include a lower vertical portion 301, an inclined portion 302, and an upper vertical portion 303.

The lower vertical portion 301 may be disposed at the edge of the lower plate 20. The lower vertical portion 301 may be disposed perpendicular to the lower plate 20. The lower vertical portion 301 may be formed to protrude upward from the upper surface of the lower plate 20.

The upper vertical portion 303 may be disposed at the edge of the upper plate 10. The upper vertical portion 303 may be disposed perpendicular to the upper plate 10. The upper vertical portion 303 may be formed to protrude downward from the lower surface of the upper plate 10.

The inclined portion 302 may be formed to connect the lower vertical portion 301 and the upper vertical portion 303. In other words, one end of the inclined portion 302 may be connected to the upper vertical portion 303, and the other end of the inclined portion 302 may be connected to the lower vertical portion 301. The inclined portion 302 may be disposed to be inclined with respect to the upper vertical portion 303 and the lower vertical portion 301. The inclined portion 302 may be disposed to form an acute or obtuse angle with respect to the upper vertical portion 303 and the lower vertical portion 301.

The straight line connecting the upper vertical portion 303 and the lower vertical portion 301 may not be parallel to a virtual straight line perpendicular to the upper plate 10 and the lower plate 20. In other words, a side surface of the upper vertical portion 303 may not be located on a virtual straight line that passes through a side surface of the lower vertical portion 301 and is perpendicular to the lower plate 20.

The plurality of connection members 30 may be integrally formed of a non-conductive elastic material. Then, the distance between the upper plate 10 and the lower plate 20 may be adjusted. That is, the length of the surface mount gasket 1 may be reduced or increased. In other words, the surface mount gasket 1 may be increased or decreased in length within a certain range. For example, the surface mount gasket 1 may be decreased or increased in length within about 1 mm.

A conductive coating layer may be formed on the outer surface of each of the plurality of connection members 30. The conductive coating layer may be formed to have electrical conductivity and thermal conductivity.

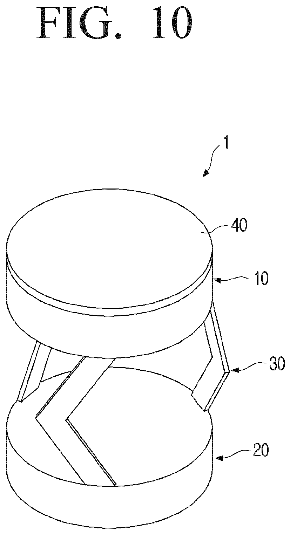

FIG. 10 is a perspective view illustrating a surface mount gasket 1 according to one or more embodiments of the disclosure.

Referring to FIG. 10, a surface mount gasket 1 according to one or more embodiments of the disclosure may include an upper plate 10, a lower plate 20, and a plurality of connection members 30. In addition, the surface mount gasket 1 may include a double-sided tape 40 disposed on the upper surface of the upper plate 10.

The upper plate 10, the lower plate 20, and the double-sided tape 40 are the same as those of the surface mount gasket 1 according to the above-described embodiment; therefore, detailed descriptions thereof are omitted.

Each of the plurality of connection members 30 may be bent at least once to include a bend or bent portion. In other words, each of the plurality of connection members 30 may be formed in a wide V shape.

One end of each of the plurality of connection members 30 may be disposed at an edge of the upper plate 10, and the other end thereof may be disposed at an edge of the lower plate 20. The plurality of connection members 30 may be disposed at a certain interval along the edge of the upper plate 10 and the edge of the lower plate 20.

The plurality of connection members 30 may be formed identically. Accordingly, a single connection member 30 will be described below.

The connection member 30 may be formed in a wide V shape. The connection member 30 may be formed by bending a narrow and long belt-shaped flat plate at the center.

A straight line connecting one end of the connection member 30 connected to the upper plate 10 and the other end of the connection member 30 connected to the lower plate 20 may be parallel to a virtual straight line perpendicular to the upper plate 10 and the lower plate 20. In other words, one end of the connection member 30 connected to the upper plate 10 may be located on a virtual straight line that passes through the other end of the connection member 30 connected to the lower plate 20 and is perpendicular to the lower plate 20.

As another example, each of the plurality of connection members 30 may be formed by being bent twice. In other words, the connection members 30 may be formed in an approximately W shape.

The plurality of connection members 30 may be formed of the same materials as the plurality of connection members 30 of the surface mount gasket 1 according to the above-described embodiment.

As described above, when the plurality of connection members 30 are formed in a shape in which they are bent at least once, the length of the connection members 30 may be increased or decreased.

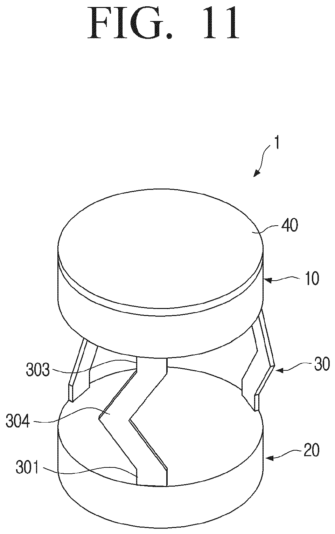

FIG. 11 is a perspective view illustrating a surface mount gasket 1 according to one or more embodiments of the disclosure.

Referring to FIG. 11, a surface mount gasket 1 according to one or more embodiments of the disclosure may include an upper plate 10, a lower plate 20, and a plurality of connection members 30. In addition, the surface mount gasket 1 may include a double-sided tape 40 disposed on the upper surface of the upper plate 10.

The upper plate 10, the lower plate 20, and the double-sided tape 40 are the same as those of the surface mount gasket 1 according to the above-described embodiment; therefore, detailed descriptions thereof are omitted.

Each of the plurality of connection members 30 may be disposed at an angle with respect to the upper plate 10 and the lower plate 20. One end of each of the plurality of connection members 30 may be disposed at an edge of the upper plate 10, and the other end thereof may be disposed at an edge of the lower plate 20. The plurality of connection members 30 may be disposed at a certain interval along the edge of the upper plate 10 and the edge of the lower plate 20.

The plurality of connection members 30 may be formed identically. Accordingly, a single connection member 30 will be described below.

The connection member 30 may include a lower vertical portion 301, a bend portion 304, and an upper vertical portion 303.

The lower vertical portion 301 may be disposed at the edge of the lower plate 20.

The lower vertical portion 301 may be disposed perpendicular to the lower plate 20. The lower vertical portion 301 may be formed to protrude upward from the upper surface of the lower plate 20.

The upper vertical portion 303 may be disposed at the edge of the upper plate 10. The upper vertical portion 303 may be disposed perpendicular to the upper plate 10. The upper vertical portion 303 may be formed to protrude downward from the lower surface of the upper plate 10.

The bend portion 304 may be formed to connect the lower vertical portion 301 and the upper vertical portion 303. In other words, one end of the bend portion 304 may be connected to the upper vertical portion 303, and the other end of the bend portion 304 may be connected to the lower vertical portion 301. The bend portion 304 may be formed in a wide V shape.

A straight line connecting the upper vertical portion 303 and the lower vertical portion 301 may be parallel to a virtual straight line perpendicular to the upper plate 10 and the lower plate 20. In other words, a side surface of the upper vertical portion 303 may be located on a virtual straight line that passes through a side surface of the lower vertical portion 301 and is perpendicular to the lower plate 20.

The plurality of connection members 30 may be formed of the same materials as the plurality of connection members 30 of the surface mount gasket 1 according to the above-described embodiment.

When the plurality of connection members 30 are formed in a shape including the upper vertical portion 303, the bend portion 304, and the lower vertical portion 301, the length of the connection members 30 may be increased or decreased.

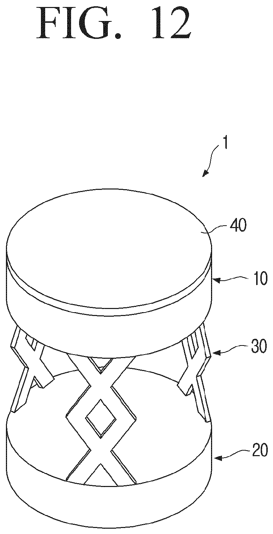

FIG. 12 is a perspective view illustrating a surface mount gasket 1 according to one or more embodiments of the disclosure.

Referring to FIG. 12, a surface mount gasket 1 according to one or more embodiments of the disclosure may include an upper plate 10, a lower plate 20, and a plurality of connection members 30. In addition, the surface mount gasket 1 may include a double-sided tape 40 disposed on the upper surface of the upper plate 10.

The upper plate 10, the lower plate 20, and the double-sided tape 40 are the same as those of the surface mount gasket 1 according to the above-described embodiment; therefore, detailed descriptions thereof are omitted.

Each of the plurality of connection members 30 may be disposed at an angle with respect to the upper plate 10 and the lower plate 20. One end of each of the plurality of connection members 30 may be disposed at an edge of the upper plate 10, and the other end thereof may be disposed at an edge of the lower plate 20. The plurality of connection members 30 may be disposed at a certain interval along the edge of the upper plate 10 and the edge of the lower plate 20.

The plurality of connection members 30 may be formed identically. Accordingly, a single connection member 30 will be described below.

The connection member 30 may be formed in two X-shapes. In other words, the connection member 30 may be formed in the shape of two X characters connected in the longitudinal direction.

One end of the two X-shaped connection member 30 may be connected to an edge of the upper plate 10, and the other end thereof may be connected to an edge of the lower plate 20.

When the connection member 30 is formed in two X-shapes connected in the longitudinal direction, the length of the connection member 30 may be increased or decreased.

The plurality of connection members 30 may be formed of the same material as the plurality of connection members 30 of the surface mount gasket 1 according to the above-described embodiment.

In FIG. 12, the connection members 30 are formed by connecting two X-shaped parts in the longitudinal direction. However, the number of X-shaped parts to be connected is not limited thereto. As another example, the connection members 30 may be formed by connecting three or more X-shaped parts in the longitudinal direction.

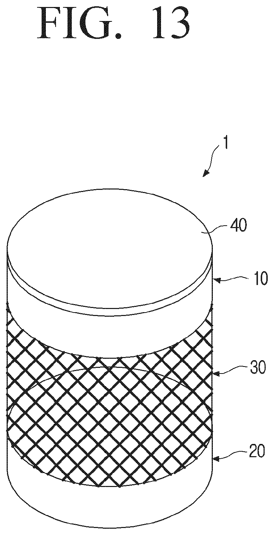

FIG. 13 is a perspective view illustrating a surface mount gasket 1 according to one or more embodiments of the disclosure.

Referring to FIG. 13, a surface mount gasket 1 according to one or more embodiments of the disclosure may include an upper plate 10, a lower plate 20, and a plurality of connection members 30. In addition, the surface mount gasket 1 may include a double-sided tape 40 disposed on the upper surface of the upper plate 10.

The upper plate 10, the lower plate 20, and the double-sided tape 40 are the same as those of the surface mount gasket 1 according to the above-described embodiment; therefore, detailed descriptions thereof are omitted.

The plurality of connection members 30 may be formed in a mesh shape or a net shape.

One end of the mesh may be connected to an edge of the upper plate 10, and the other end thereof may be connected to an edge of the lower plate 20.

The mesh may be formed in a hollow cylindrical shape. Accordingly, one end of the mesh may be disposed along the entire circumference of the edge of the upper plate 10, and the other end thereof may be disposed along the entire circumference of the edge of the lower plate 20.

The mesh or net may be formed of the same material as the plurality of connection members 30 of the surface mount gasket 1 according to the above-described embodiment.

When the plurality of connection members 30 are formed in the mesh shape or the net shape, the distance between the upper plate 10 and the lower plate 20 may be increased or decreased.

While the disclosure has been illustrated and described above with reference to various embodiments, it will be understood by those skilled in the art that various changes in form and detail may be made therein without departing from the scope of the disclosure as defined by the appended claims.

## Claims

1. A surface mount gasket (1) comprising:
an upper plate (10);
a lower plate (20) arranged below the upper plate (10); and
a plurality of connection members (30) connecting the upper plate (10) and the lower plate (20),
wherein one end of each of the plurality of connection members (30) is connected to an edge of the upper plate (10), and another end thereof is connected to an edge of the lower plate (20), and
wherein the plurality of connection members (30) are disposed at a specified interval along the edge of the upper plate (10) and the edge of the lower plate (20).

2. The surface mount gasket of claim 1, wherein
each of the plurality of connection members (30) is inclined with respect to the upper plate (10) and the lower plate (20).

3. The surface mount gasket of claim 2, wherein
each of the plurality of connection members (30) is formed of an elastic material having a thin flat plate shape with a narrow width and a long length.

4. The surface mount gasket of claim 3, wherein
the plurality of connection members (30) are formed of a sponge, and
wherein a metal coating layer is formed on an outer surface of the sponge.

5. The surface mount gasket of claim 2, wherein
the upper plate (10), the lower plate (20), and the plurality of connection members (30) are integrally formed of a non-conductive elastic material, and
wherein a conductive coating layer is formed on an outer surface of the upper plate (10), an outer surface of the lower plate (20), and outer surfaces of the plurality of connection members (30).

6. The surface mount gasket of claim 1, further comprising:
a double-sided tape (40) disposed on an upper surface of the upper plate (10).

7. The surface mount gasket of claim 1, wherein
each of the plurality of connection members (30) is formed by being bent at least once.

8. The surface mount gasket of claim 1, wherein
each of the plurality of connection members (30) is formed in two X-shapes connected in a longitudinal direction.

9. The surface mount gasket of claim 1, wherein
the plurality of connection members (30) are formed in a mesh shape.

10. The surface mount gasket of claim 1, wherein
the upper plate (10) and the lower plate (20) are formed in one of a circle, an oval, and a rectangle.

11. The surface mount gasket of claim 1, wherein
each of the plurality of connection members (30) includes an upper vertical portion, an inclined portion, and a lower vertical portion.

12. The surface mount gasket of claim 1, wherein
each of the plurality of connection members (30) includes an upper vertical portion, a bend portion, and a lower vertical portion.

## Patentansprüche

1. Oberflächenmontierte Dichtung (1), umfassend:
eine obere Platte (10);
eine untere Platte (20), die unterhalb der oberen Platte (10) angeordnet ist; und
eine Vielzahl von Verbindungselementen (30), die die obere Platte (10) und die untere Platte (20) verbinden,
wobei ein Ende von jedem der Vielzahl von Verbindungselementen (30) mit einem Rand der oberen Platte (10) verbunden ist und ein anderes Ende davon mit einem Rand der unteren Platte (20) verbunden ist, und
wobei die Vielzahl von Verbindungselementen (30) in einem spezifischen Abstand entlang des Rands der oberen Platte (10) und des Rands der unteren Platte (20) angeordnet ist.

2. Oberflächenmontierte Dichtung nach Anspruch 1, wobei
jedes der Vielzahl von Verbindungselementen (30) in Bezug auf die obere Platte (10) und die untere Platte (20) geneigt ist.

3. Oberflächenmontierte Dichtung nach Anspruch 2, wobei
jedes der Vielzahl von Verbindungselementen (30) aus einem elastischen Material gebildet ist und eine dünne flache Plattenform mit einer schmalen Breite und einer großen Länge aufweist.

4. Oberflächenmontierte Dichtung nach Anspruch 3, wobei
die Vielzahl von Verbindungselementen (30) aus einem Schwamm gebildet ist, und
wobei auf einer Außenfläche des Schwamms eine Metallbeschichtungsschicht gebildet ist.

5. Oberflächenmontierte Dichtung nach Anspruch 2, wobei
die obere Platte (10), die untere Platte (20) und die Vielzahl von Verbindungselementen (30) einstückig aus einem nichtleitenden, elastischen Material gebildet sind, und
wobei auf einer Außenfläche der oberen Platte (10), einer Außenfläche der unteren Platte (20) und den Außenflächen der Vielzahl von Verbindungselementen (30) eine leitende Beschichtungsschicht gebildet ist.

6. Oberflächenmontierte Dichtung nach Anspruch 1, ferner umfassend:
ein doppelseitiges Klebeband (40), das auf einer oberen Fläche der oberen Platte (10) angeordnet ist.

7. Oberflächenmontierte Dichtung nach Anspruch 1, wobei
jedes der Vielzahl von Verbindungselementen (30) durch mindestens einmaliges Biegen geformt wird.

8. Oberflächenmontierte Dichtung nach Anspruch 1, wobei
jedes der Vielzahl von Verbindungselementen (30) in zwei X-Formen gebildet ist, die in einer Längsrichtung verbunden sind.

9. Oberflächenmontierte Dichtung nach Anspruch 1, wobei
die Vielzahl von Verbindungselementen (30) netzförmig gebildet ist.

10. Oberflächenmontierte Dichtung nach Anspruch 1, wobei
die obere Platte (10) und die untere Platte (20) in einem von einem Kreis, einem Oval oder einem Rechteck gebildet ist.

11. Oberflächenmontierte Dichtung nach Anspruch 1, wobei
jedes der Vielzahl von Verbindungselementen (30) einen oberen vertikalen Abschnitt, einen geneigten Abschnitt und einen unteren vertikalen Abschnitt beinhaltet.

12. Oberflächenmontierte Dichtung nach Anspruch 1, wobei
jedes der Vielzahl von Verbindungselementen (30) einen oberen vertikalen Abschnitt, einen gebogenen Abschnitt und einen unteren vertikalen Abschnitt beinhaltet.

## Revendications

1. Joint d'étanchéité à montage en surface (1) comprenant :
une plaque supérieure (10) ;
une plaque inférieure (20) agencée sous la plaque supérieure (10) ; et
une pluralité d'éléments de liaison (30) reliant la plaque supérieure (10) et la plaque inférieure (20),
une extrémité de chacun de la pluralité d'éléments de liaison (30) étant reliée à un bord de la plaque supérieure (10), et une autre extrémité de celle-ci étant reliée à un bord de la plaque inférieure (20), et
ladite pluralité d'éléments de liaison (30) étant disposés à un intervalle spécifié le long du bord de la plaque supérieure (10) et du bord de la plaque inférieure (20).

2. Joint d'étanchéité à montage en surface de la revendication 1,
chacun de la pluralité d'éléments de liaison (30) étant incliné par rapport à la plaque supérieure (10) et à la plaque inférieure (20).

3. Joint d'étanchéité à montage en surface de la revendication 2,
chacun de la pluralité d'éléments de liaison (30) étant formé d'un matériau élastique possédant une forme de plaque plate mince avec une largeur étroite et une longueur longue.

4. Joint d'étanchéité à montage en surface de la revendication 3,
ladite pluralité d'éléments de liaison (30) étant formés d'une éponge, et
une couche de revêtement métallique étant formée sur une surface externe de l'éponge.

5. Joint d'étanchéité à montage en surface de la revendication 2,
ladite plaque supérieure (10), ladite plaque inférieure (20) et ladite pluralité d'éléments de liaison (30) étant formés d'un seul tenant d'un matériau élastique non conducteur, et
une couche de revêtement conductrice étant formée sur une surface externe de la plaque supérieure (10), une surface externe de la plaque inférieure (20), et des surfaces externes de la pluralité d'éléments de liaison (30).

6. Joint d'étanchéité à montage en surface de la revendication 1, comprenant en outre :
un ruban double face (40) disposé sur une surface supérieure de la plaque supérieure (10).

7. Joint d'étanchéité à montage en surface de la revendication 1,
chacun de la pluralité d'éléments de liaison (30) étant formé en étant plié au moins une fois.

8. Joint d'étanchéité à montage en surface de la revendication 1,
chacun de la pluralité d'éléments de liaison (30) étant formé en deux formes en X reliées dans une direction longitudinale.

9. Joint d'étanchéité à montage en surface de la revendication 1,
ladite pluralité d'éléments de liaison (30) étant formés dans une forme de maille.

10. Joint d'étanchéité à montage en surface de la revendication 1,
ladite plaque supérieure (10) et ladite plaque inférieure (20) étant formées dans l'un d'un cercle, d'un ovale et d'un rectangle.

11. Joint d'étanchéité à montage en surface de la revendication 1,
chacun de la pluralité d'éléments de liaison (30) comprenant une partie verticale supérieure, une partie inclinée et une partie verticale inférieure.

12. Joint d'étanchéité à montage en surface de la revendication 1,
chacun de la pluralité d'éléments de liaison (30) comprenant une partie verticale supérieure, une partie pliée et une partie verticale inférieure.
